## Europäisches Patentamt
## European Patent Office
## Office européen des brevets

(19)

(11) Veröffentlichungsnummer: **0 176 028 B1**

(12) # EUROPÄISCHE PATENTSCHRIFT

(45) Veröffentlichungstag der Patentschrift: **12.08.92**

(51) Int. Cl.5: **H01S 3/19**, H01L 33/00

(21) Anmeldenummer: **85111813.3**

(22) Anmeldetag: **18.09.85**

(54) **Verfahren zur Herstellung einer Laserdiode mit vergrabener aktiver Schicht und mit seitlicher Strombegrenzung durch selbstjustierten pn-übergang.**

(30) Priorität: **25.09.84 DE 3435148**

(43) Veröffentlichungstag der Anmeldung:
**02.04.86 Patentblatt 86/14**

(45) Bekanntmachung des Hinweises auf die
Patenterteilung:
**12.08.92 Patentblatt 92/33**

(84) Benannte Vertragsstaaten:
**DE FR GB**

(56) Entgegenhaltungen:
**FR-A- 2 417 195**
**FR-A- 2 493 616**
**GB-A- 2 080 014**
**US-A- 4 269 635**
**US-A- 4 426 700**

**APLLIED PHYSICS LETTERS, Band 43, Nr. 9,
1. November 1983, Seiten 809-811, American
Institute of Physics, New York, US; T.G.J.
VAN OIRSCHOT et al.: "Ridged substrate internally diffused stripe AlGaAs laser emitting in the visible wavelength region"**

**IEEE JOURNAL OF OUANTUM ELECTRONICS,
Band OE-15, Nr. 6, Juni 1979, Seiten 451-469,**

**IEEE, New York, US; W.T. TSANG et al.:
"GaAs-AlxGa1-xAs strip buried heterostructure lasers"**

(73) Patentinhaber: **SIEMENS AKTIENGESELL-
SCHAFT
Wittelsbacherplatz 2
W-8000 München 2(DE)**

(72) Erfinder: **Amann, Markus-Christian, Dr.
Unterhachinger Strasse 89
W-8000 München 83(DE)**

## Beschreibung

Die vorliegende Erfindung bezieht sich auf ein Verfahren zur Herstellung einer Laserdiode, wie im Oberbegriff des Patentanspruchs 1 angegeben.

Laserdioden des Typs mit vergrabener aktiver Schicht (Buried Hetero-Laser), zu dem auch die Laserdiode der vorliegenden Erfindung gehört, sind bekannt aus z.B. der US-PS 4 426 700 und aus IEEE Journ. of Quantum Electronics, Bd. QE-15 (1979), S. 451 bis 469, wobei diese Druckschrift mehr die theoretischen Fragen erörtert. Es handelt sich hier um Laserdioden in einem Halbleiterkörper mit Hetero-Schichtaufbau. Zur Erzielung geringster Schwellenströme ist die räumliche Anordnung derart getroffen, daß sich die aktive Schicht, die die Form eines schmalen Streifens, auch als Steg bezeichnet, hat, innerhalb des Schichtaufbaues befindet, d.h. vergraben ist, wobei dieser schmale Streifen von Halbleitermaterial mit niedrigerem Brechungsindex und höherem Bandabstand flankiert ist. Die Anordnung ist so getroffen und die Laserdiode ist so aufgebaut, daß der zugeführte, zur Erzeugung der Laserstrahlung dienende elektrische Strom auf diesen schmalen Streifen konzentriert ist, und daß durch Nebenschlüsse in der Nachbarschaft des aktiven Streifens auftretende Leckströme unterdrückt sind. Für die Unterdrückung solcher Leckströme sind zum einen Isolierschichten verwendet worden. Es ist auch bekannt, hierfür sperrende pn-Übergänge zu verwenden, wobei stets das Problem besteht, daß dadurch der durch den aktiven Streifen fließende elektrische Strom unerwünschterweise beeinträchtigt wird. Durch örtlich selektives Aufwachsen von pn-Übergangsschichten neben dem aktiven Streifen läßt sich zwar das Auftreten einer solchen Beeinflussung vermeiden, doch ist dies ein sehr aufwendiges Herstellungsverfahren.

Lediglich der Vollständigkeit halber sei auf einen die seitlichen Zonen mit niedrigerem Brechungsindex und höherem Bandabstand nicht umfassenden anderen Typ (gain-guided) einer Laserdiode hingewiesen, der z.B. in der DE-OS 28 19 843 und in Appl. Phys. Lett., Bd. 43 (1983) S. 809 bis 811 sowie Bd. 44 (1984) S. 1035 bis 1037 beschrieben ist.

Aufgabe der vorliegenden Erfindung ist es, ein solches Herstellungsverfahren einer Laserdiode des Typs vergrabener streifenförmiger aktiver Schicht anzugeben, bei dem der seitlich angeordnete pn-Übergang, der der Eingrenzung des Stromes auf den aktiven Streifen dient, in einfacher Weise anzubringen ist und dennoch keine Beeinflussung des der LaserstrahlungsErzeugung dienenden, durch den aktiven Streifen fließenden Stromes bewirkt wird.

Diese Aufgabe ist mit dem Verfahren zur Herstellung einer Laserdiode gelöst, das die Merkmale des Kennzeichens des Patentanspruchs 1 aufweist. Weitere Ausgestaltungen und Weiterbildungen dieses Herstellungsverfahrens gehen aus den Unteransprüchen hervor.

Ein bekanntes Verfahren zur Herstellung einer Laserdiode mit vergrabener aktiver Schicht, eingeschlossen seitliche Bereiche mit niedrigerem Brechungsindex und höherem Bandabstand, ist entsprechend der US-PS 4 426 700 in der Weise durchgeführt worden, daß auf einem Substratkörper zunächst ganzflächig die Hetero-Schichtstruktur der Diode erzeugt worden ist und dann der den schmalen Streifen der aktiven Schicht enthaltende Steg durch maskiertes Ätzen, d.h. durch Wegätzen der seitlichen Zonen, hergestellt worden ist. Erst nachfolgend werden dann diese Zonen seitlich des Steges wieder mit epitaktisch abgeschiedenem Halbleitermaterial neu aufgefüllt. Diese Maßnahmen sind umständlich und es ist auch schwierig, die genaue Lage eines pn-Überganges zu gewährleisten, der im Zusammenhang mit diesem Wiederauffüllen und sich seitlich des Steges erstreckend zu erzeugen ist.

Ein der Erfindung zugrundeliegender Gedanke ist, einzelne Verfahrensparameter des Herstellungsverfahrens einer erfindungsgemäßen Diode so zu bemessen bzw. auszugestalten, daß sich der gewünschte pn-Übergang prinzipiell im Verlauf des Herstellungsverfahrens ergibt. Insbesondere ist bei der Erfindung vorgesehen, daß dieser pn-Übergang selbstjustierend entsteht. Bei der erfindungsgemäßen Laserdiode ist eine Schicht vorgesehen, die einen stark diffundierenden, derartigen Dotierungsstoff enthält, der im Verlauf eines Wärmebehandlungsprozesses bzw. Temperprozesses in eine andere der Schichten des Schichtaufbaues eindiffundiert und dort Umdotierung bewirkt. Dabei ist diese andere Schicht eine solche Schicht, die von der den Dotierungsstoff ursprünglich (allein) enthaltenden, erstgenannten Schicht durch eine dazwischenliegende weitere Schicht des gesamten Schichtaufbaues getrennt ist. Zur Erfindung gehört aber weiterhin die Auswahl und die Bemessung, daß diese weitere Schicht gegenüber der erstgenannten Schicht so dotiert ist, daß sie gegenüber dieser erstgenannten Schicht entgegengesetzt dotiert ist.

Das Maß dieser Dotierung dieser weiteren Schicht ist so gewählt, daß bei der während der Wärmebehandlung erfolgenden Ausdiffusion des Dotierstoffes aus der erstgenannten Schicht der Leitungstyp dieser weiteren angrenzenden Schicht nicht umgeändert wird. Die Bemessungen sind des weiteren aber auch so gewählt, daß der durch diese weitere Schicht hindurch bis in die andere Schicht diffundierende Anteil des Dotierstoffes dort in dieser anderen Schicht wenigstens im Grenzbereich zwischen dieser anderen Schicht und der weiteren Schicht eine solche Umdotierung bewirkt, daß nunmehr ein pn-Übergang zwischen diesem umdotierten Anteil der anderen Schicht und der in ihrem Dotierungstypus noch unverändert gebliebenen weiteren Schicht entstanden ist. Des weiteren sind die Bemessungen, insbesondere die der Dotierungsgrade, so getroffen, daß für die dem laseraktiven Streifen zugehörenden Schichten der vergrabenen Laserzone keine Umdotierung eintritt.

Weitere Erläuterungen der Erfindung werden mit Hilfe der nachfolgenden, anhand der Figuren gegebenen Beschreibung von Ausführungsbeispielen der Erfindung gemacht.

Fig.1 bis 3          zeigen Verfahrensschritte zur Hestellung einer ersten Ausführungsform.

Fig.4                 zeigt das fertige Beispiel dieser eisten Ausführungsform.

Fig.5 und 6          zeigen Verfahrensschritte, die zu einer zweiten Ausführungsform der Erfindung führen.

Fig.7                 zeigt eine Laserdiode dieser zweiter Ausführungsform.

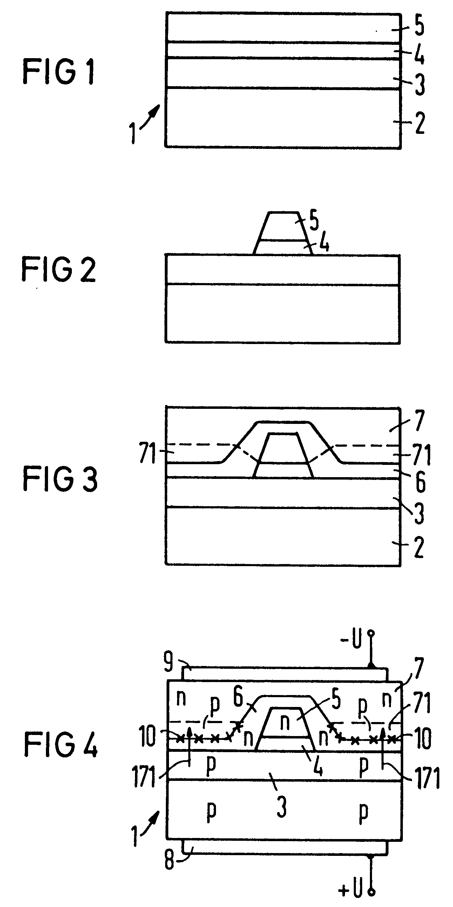

In Fig.1 ist ein Hetero-Schichtaufbau dargestellt, wie er für Laser mit vergrabener aktiver Schicht prinzipiell üblicherweise verwendet wird. Mit 2 ist ein Halbleiter-Substrat bezeichnet, das z.B. aus p-leitendem Indiumphosphid besteht. Die darauf befindliche erste Schicht 3 besteht beispielsweise aus p-leitendem Indiumphosphid, das erfindungsgemäß mit einem Dotierstoff dotiert ist, der einen hohen Diffusionskoeffizienten hat, d.h. stark diffundierende Neigung zeigt. Insbesondere ist ein solcher Dotierstoff Zink. Es kommt aber auch Kadmium und/oder Magnesium hierfür in Betracht. Die zweite Schicht 4 besteht z.B. aus Indiumgalliumarsenidphosphid. Sie ist die eigentliche aktive Schicht und vorzugsweise undotiert. Die Schicht 5 besteht z.B. aus n-leitendem Indiumphosphid. Verwendet wird für diese Schicht ein Dotierstoff der (vergleichsweise zu demjenigen der Schicht 3) einen weniger hohen, insbesondere sehr kleinen, Diffusionskoeffizienten hat. Dieser der Art nach bekannte Schichtaufbau enthält somit einen pn-Übergang, der im Betrieb der Laserdiode in Flußrichtung gepolt ist.

Fig.2 zeigt das Ergebnis eines Ätzprozesses, mit dessen Hilfe die übliche streifenförmige Struktur der Schichten 4 und 5, d.h. der laseraktiven Zone der Schicht 4 und der anschließenden Kontaktschicht 5, ist.

Fig.3 zeigt zusätzlich zwei weitere aufgebrachte Schichten, nämlich die Schichten 6 und 7. Die Schicht 6, die oben als weitere Schicht bezeichnet worden ist, besteht beispielsweise aus n-leitendem Indiumphosphid. Sie ist mit vorzugsweise nur schwach diffundierendem Dotierstoff dotiert, z.B. mit Zinn, Tellur oder Germanium. Die nächstfolgende Schicht 7, die oben als andere Schicht bezeichnet worden ist, ist wieder n-leitend und besteht beispielsweise ebenfalls aus Indiumphosphid und schwach diffundierendem Dotierstoff.

(Weiter) wichtig für die Erfindung ist, daß der Dotierungsgrad der weiteren Schicht 6 soviel höher ist als derjenige der anderen Schicht 7, daß bei Wärmebehandlung aus der erstgenannten Schicht 3 in die Schichten 6 und 7 diffundierender Dotierstoff, z.B. das in Schicht 3 enthaltene Zink, in der weiteren Schicht 6 noch keine Umdotierung bewirkt, wohl aber in der Schicht 7 die mit 71 bezeichnete Zone der Schicht 7 umdotiert. Diese Zone 71 erstreckt sich rechts und links von der streifenförmigen aktiven Schicht 4. Von der Zone 71 aus gesehen, die aufgrund der (zusätzlichen) Zinkdotierung p-leitend geworden ist, folgt die nach wie vor n-leitend gebliebene Schicht 6 und anschließend die p-leitende Schicht 3. Es liegt somit von der Zone 71 zur Schicht 3 ein pnp-Übergang vor, der einen für den Strom neben dem Laserstreifen sperrenden pn-Übergang enthält. Dieser sperrende pn-Übergang ist aufgrund des gesamten Herstellungsverfahrens der erfindungsgemäßen Laserdiode selbstjustierend entstanden.

Der Prozeß der Wärmebehandlung kann getrennt ausgeführt werden. Die Wärmebehandlung kann aber auch bereits Bestandteil des Epitaxie-Verfahrens der Schichten 6 und 7 sein, d.h. die Diffusion des Zinks kann bereits im Verlauf des Enstehens der Schichten 6 und 7 erfolgen.

Fig.4 zeigt eine fertige, nach den Verfahrensschritten der Fig.1 bis 3 hergestellte Laserdiode. Sie ist zusätzlich mit den Elektroden 8 und 9 versehen, die zum Anschluß der elektrischen Speisespannung dienen. Aus den in dieser Figur angegebenen Dotierungen, die als Beispiel zu verstehen sind, ist zu ersehen, daß im Bereich des laseraktiven Streifens erwünschterweise der in Flußrichtung gepolte pn-Übergang unverändert vorliegt. Rechts und links von dieser streifenförmigen Zone 4 liegen die erfindungsgemäß hergestellten sperrenden pn-Übergänge 10 (in der Figur mit Kreuzen hervorgehoben), die bewirken, daß der Stromfluß auf die streifenförmige laseraktive Zone eingeschränkt wird. Auch an der fertigen Laserdiode nach Fig.4 ist das erfindungsgemäße Herstellungsverfahren zu erkennen, nämlich aufgrund der für die Erfindung ganz charakteristischen Verteilungen der Dotierungen und der relativen Bemessungen der Dotierungen zueinander.

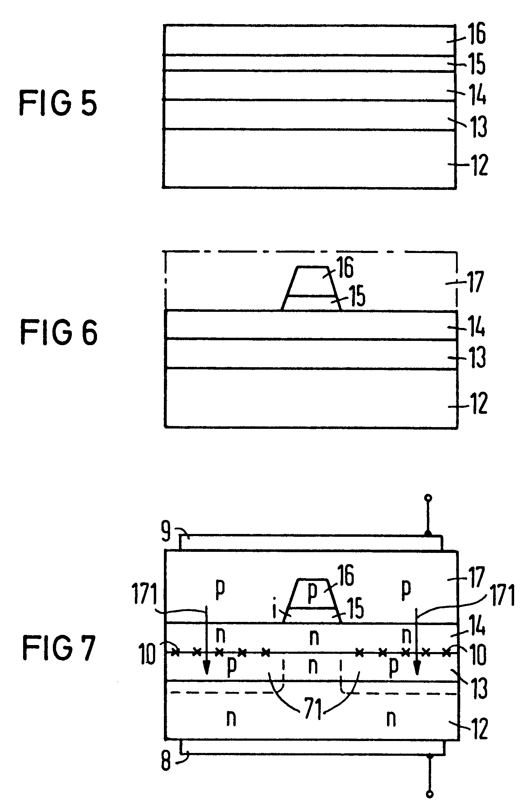

Die Fig.5 bis 7 zeigen die Verfahrensschritte eines weiteren erfindungsgemäßen Herstellungsverfahrens. Mit 12 ist das Halbleitersubstrat bezeichnet, das hier jedoch n-leitend, beispielsweise wiederum Indiumphosphid, ist. Die darauffolgende erste Schicht 13 ist ebenfalls n-leitend, beispielsweise zinndotiertes Indiumphosphid. Die nächstfolgende Schicht 14 ist n-leitend und beispielsweise wiederum zinndotiertes Indiumphosphid, jedoch mit vergleichsweise zur Schicht 13 höherem Dotierungsgrad. Die nächstfolgende Schicht 15 ist die eigentliche (mit der Schicht 4 zu vergleichende) aktive Schicht aus beispielsweise Indiumgalliumarsenidphosphid, das z.B. undotiert ist. Die nächstfolgende Schicht 16 ist p-leitend, z.B.

zinkdotiertes Indiumphosphid.

Fig.6 zeigt das Ergebnis des Verfahrensschrittes der Ätzung mit dem in der Figur zu erkennenden streifenförmigen Aufbau der aktiven Zone 15 und 16.

Fig.7 zeigt außerdem mit gestrichelten Linien die Aufbringung einer nächsten Schicht 17, die diejenige Schicht ist, die den gemäß der Erfindung vorgesehenen Dotierstoff mit großem Diffusionskoeffizienten enthält. Bei diesem Beispiel ist dies p-Leitung bewirkender Dotierstoff, insbesondere Zink, Kadmium oder Magnesium. Ebenfalls gemäß der Erfindung ist vorgesehen, daß der Dotierungsgrad der hier n-leitenden Schicht 14 soviel größer gewählt ist als derjenige der ebenfalls n-leitenden Schicht 13, daß durch die Schicht 14 (bei entsprechender Wärmebehandlung) aus der Schicht 17 ein- und hindurchdiffundierender p-Dotierstoff den Leitungstyp dieser Schicht 14 nicht verändert, wohl aber denjenigen der Schicht 13 umändert.

Fig.7 zeigt das Ergebnis des erfindungsgemäßen Herstellungs-verfahrens, nämlich die mit den Elektroden 8 und 9 versehene Laserdiode des zweiten Ausführungsbeispiels. Ebenso wie die Laserdiode nach Fig.5 hat auch die Laserdiode nach Fig.8 außerhalb der eigentlichen laseraktiven Zone der Streifen 3 und 4 eine pnp-Struktur mit sperrendem pn-Übergang 10. Nachfolgend werden die Erfindung betreffende Bemessungen zu den beiden Ausführungsbeispielen gegeben.

1. Ausführungsbeispiel:

Schicht 3    p-InP; Zn-dotiert, z.B. $P_3=1$ bis $10 \times 10^{17} \mathrm{cm}^{-3}$

"   4    InGaAsP (akt.Schicht, z.B. undotiert)

"   5    n-InP; Sn-dotiert, z.B. $N = 2 \times 10^{18} \mathrm{cm}^{-3}$

"   6    n-InP; Sn-dotiert, z.B. $N_6 = 2 \times 10^{18} \mathrm{cm}^{-3}$

"   7    n-InP; Sn-dotiert, z.B. $N_7 = 5 \times 10^{16} \mathrm{cm}^{-3}$

also $N_6 \quad P_3 \quad N_7$ sowie $N_5 \quad P_3$

2. Ausführungsbeispiel:

"   13    n-InP; Sn-dotiert, z.B. $N_{13} = 2 \times 10^{17} \mathrm{cm}^{-3}$

"   14    n-InP; Sn-dotiert, z.B. $N_{14} = 2 \times 10^{18} \mathrm{cm}^{-3}$

"   15    InGaAsP (akt. Schicht; z.B. undotiert)

"   16    p-InP; Zn-dotiert, z.B. $P_{16} = 1 \times 10^{17} \mathrm{cm}^{-3}$

"   17    p-InP; Zn-dotiert, z.B. $P_{17} = 5 \times 10^{17} \mathrm{cm}^{-3}$

also $N_{14} \quad P_{17} \quad N_{13}$ sowie $N_{14} \quad P_{16}$

**Patentansprüche**

1. Verfahren zur Herstellung einer Laserdiode mit laseraktivem Streifen in einer vergrabenen Schicht (4, 15) eines Heteroschichtaufbaus aus III-V-Halbleitermaterial, bei dem dieser Streifen durch Zonen (71) seitlich flankiert ist, die eine Dotierung aufweisen, deren Leitungstyp zu dem der Dotierung einer angrenzenden Schicht (6, 14) entgegengesetzt ist, wodurch ein sperrender pn-Übergang (10) gebildet wird, so daß Strombegrenzung auf den laseraktiven Streifen bewirkt wird,

**gekennzeichnet dadurch,**

- daß man aus einer ersten Schicht (3, 17) einen Dotierstoff mit in dem Halbleitermaterial hohem Diffusionskoeffizienten unter Wärmeeinwirkung ausdiffundieren läßt,
- daß dieser Dotierstoff durch eine an die erste Schicht angrenzende zweite Schicht (6, 14) mit zur ersten Schicht entgegengesetztem Leitungstyp hindurchdiffundiert (171) wird, und
- daß dieser Dotierstoff in eine auf die zweite Schicht folgende dritte Schicht (7, 13) mit zur ersten Schicht (3, 17) entgegengesetztem Leitungstyp so eindiffundiert wird, daß dort durch Umdotierung die den laseraktiven Streifen flankierenden Zonen (71, 113) gebildet werden,
- wobei der Dotierungsgrad der Dotierung der zweiten Schicht zur Vermeidung einer Umdotierung auch in dieser zweiten Schicht ausreichend höher als der Dotierungsgrad der Dotierung in der dritten Schicht eingestellt worden ist, die dort die Grunddotierung mit dem der Umdotierung entgegengesetzten Leitungstyp ist, und
- wobei die Grunddotierungen der zweiten und der dritten Schicht durch einen Dotierungsstoff gegeben sind, der vergleichsweise zum Dotierungsstoff der Umdotierung einen wesentlich kleineren Diffusionskoeffizienten hat.

2. Verfahren nach Anspruch 1,
- bei dem zunächst die zur Laser-Heterostruktur gehörenden Schichten (3, 4, 5) nacheinander aufeinander abgeschieden werden,
- bei dem aus wenigstens den zwei zuletzt abgeschiedenen Schichten (4, 5), eingeschlossen die als laseraktive Schicht vorgesehene Schicht (4), eine Streifenstruktur (4 mit 5) hergestellt wird,
- daß auf der ersten Schicht (3) dieser Heterostruktur wenigstens in den die Streifenstruktur seitlich flankierenden Bereichen (71) zunächst die weitere zweite Schicht (6) und darauf die folgende dritte Schicht (7) abgeschieden wird und
- daß schon im Verlauf der Abscheidung der dritten Schicht (7) oder wenigstens nachfolgend ein solcher Wärmeprozeß durchgeführt wird, bei dem Dotierstoff aus den die Streifenstruktur seitlich flankierenden, nicht weggeätzten Bereichen der ersten Schicht durch diese weitere zweite Schicht (6) hindurch in wenigstens an die zweite Schicht (6) angrenzende Zonen (71) dieser folgenden dritten Schicht (7) eindiffundiert (171) wird.

3. Verfahren nach Anspruch 1,
- bei dem zunächst die zur Laser-Heterostruktur gehörenden Schichten (13, 14, 15, 16) nacheinander aufeinander abgeschieden werden,
- bei dem aus wenigstens den zwei zuletzt abgeschiedenen Schichten (15, 16), eingeschlossen die als laseraktive Schicht vorgesehene Schicht (15), eine Streifenstruktur (15 mit 16) hergestellt wird,
- daß auf diese Heterostruktur wenigstens in den die Streifenstruktur seitlich flankierenden Bereichen (71) eine zusätzliche erste Schicht (17) abgeschieden wird und
- daß schon im Verlauf der Abscheidung dieser ersten Schicht (17) oder wenigstens nachfolgend ein solcher Wärmeprozeß durchgeführt wird, bei dem Dotierstoff aus dieser dritten Schicht (17) durch die Streifenstruktur flankierende Bereiche der angrenzenden zweiten Schicht (14) hindurch in wenigstens Zonen (71) eindiffundiert (171), die an diese zweite Schicht (14) angrenzen und sich in wenigstens die dritte Schicht (13) hinein erstrecken.

## Claims

1. Method for producing a laser diode having a laser-active stripe in a buried layer (4, 15) of a hetero-layer structure of III-V semiconductor material in which this stripe is laterally flanked by zones (71) which have a doping whose conductance type is opposite to that of the doping of an adjacent layer (6, 14), as a result of which a blocking pn-junction (10) is formed such that current limiting is effected on the laser-active stripe, characterised
- in that a dopant with a high diffusion coefficient in the semiconductor material is diffused out of a first layer (3, 17) under the influence of heat,
- in that said dopant is diffused through (171) a second layer (6, 14), which is adjacent to the first layer and has the opposite conductance type to the first layer, and
- in that said dopant is diffused into a third layer (7, 13) which follows the second layer and has the opposite conductance type to the first layer (3, 17) such that the zones (71, 113) flanking the laser-active stripe are formed there by redoping,

EP 0 176 028 B1

- the doping level of the doping of the second layer having been adjusted to be sufficiently higher than the doping level of the doping in the third layer to avoid also redoping in said second layer, which doping in the third layer is there the basic doping having the conductance type opposite to the redoping, and
- the basic dopings of the second and of the third layer being provided by a dopant which has a significantly lower diffusion coefficient in comparison with the dopant for redoping.

2. Method according to Claim 1,
   - in which the layers (3, 4, 5) associated with the laser hetero-structure are deposited initially, successively, one on top of the other,
   - in which a stripe structure (4 together with 5) is produced from at least the two finally deposited layers (4, 5), including the layer (4) provided as the laser-active layer,
   - in that, on the first layer (3) of this hetero-structure, the further second layer (6) is deposited first at least in the regions (71) which laterally flank the stripe structure and the subsequent third layer (7) is deposited thereon, and
   - in that even in the course of depositing the third layer (7), or at least subsequently, such a heat process is carried out in which dopant is diffused (171) from the regions of the first layer, which laterally flank the stripe structure and have not been etched away, through this further second layer (6) into at least zones (71), adjacent to the second layer (6), of this subsequent third layer (7).

3. Method according to Claim 1,
   - in which the layers (13, 14, 15, 16) associated with the laser hetero-structure are deposited initially, successively, one on top of the other,
   - in which a stripe structure (15 together with 16) is produced from at least the two finally deposited layers (15, 16), including the layer (15) provided as the laser-active layer,
   - in that an additional first layer (17) is deposited onto this hetero-structure at least in the regions (71) which laterally flank the stripe structure and
   - in that, even in the course of depositing this first layer (17), or at least subsequently, such a heat process is carried out in which dopant is diffused (171) from this third layer (17) through the regions of the adjacent second layer (14), which flank the stripe structure, into at least zones (71) which are adjacent to this second layer (14) and extend into at least the third layer (13).

**Revendications**

1. Procédé pour fabriquer une diode laser comportant une bande active pour l'effet laser située dans une couche ensevelie (4,15) d'une hétérostructure à couches formée d'un matériau semiconducteur (III-V), et selon lequel cette bande est flanquée latéralement de zones (71) qui possèdent un dopage dont le type de conductivité est opposé au dopage d'une couche contiguë (6,14), ce qui conduit à la formation d'une jonction pn bloquante (10), en sorte qu'on obtient une limitation du courant à la bande active pour l'effet laser,
   caractérisé par le fait
   - qu'on fait diffuser, à partir d'une première couche (3,17), une substance dopante possédant un coefficient de diffusion élevé dans le matériau semiconducteur, moyennant l'application d'une chaleur,
   - qu'on fait diffuser (171) cette substance dopante à travers une seconde couche (6,14) jouxtant la première couche et possédant un type de conductivité opposé à celui de la première couche, et
   - on fait diffuser cette substance dopante dans une troisième couche (7,13), qui succède à la seconde couche et possède un type de conductivité opposé à celui de la première couche (3,17) de manière à former en cet endroit, par modification du dopage, les zones (71,113) qui flanquent la bande active pour l'effet laser,
   - le degré de dopage de la seconde couche étant réglé, de manière à éviter un dopage inverse également dans cette seconde couche, à un niveau suffisamment supérieur au degré du dopage présent dans la troisième couche, qui est en cet endroit le dopage de base possédant le type de conductivité opposé au dopage inverse, et
   - les dopages de base des seconde et troisième couches étant déterminés par une substance dopante qui possède, comparativement à la substance dopante du dopage inverse, un coefficient de diffusion nettement plus faible.

6

2. Procédé suivant la revendication 1,
   - selon lequel on dépose tout d'abord successivement les unes sur les autres les couches (3,4,5) faisant partie de l'hétérostructure laser,
   - on forme une structure en forme de bande (4 avec 5) à partir au moins des deux couches (4,5) déposées en dernier lieu, incluant la couche (4) prévue en tant que couche active pour l'effet laser,
   - qu'on dépose sur la première couche (3) de cette hétérostructure au moins dans les zones (71) qui flanquent latéralement la structure en forme de bande, tout d'abord la seconde autre couche (6) et, sur cette dernière, la troisième couche suivante (7), et
   - que déjà lors du dépôt de la troisième couche (7) ou au moins ensuite, on exécute un traitement thermique lors duquel une substance dopante diffuse (171) depuis les zones, qui flanquent latéralement la structure en forme de bande et n'ont pas été éliminées par corrosion, de la première couche, en traversant cette autre seconde couche (6) et en pénétrant dans des zones (71), qui jouxtent au moins la seconde couche (6), de cette troisième couche successive (7).

3. Procédé suivant la revendication 1,
   - selon lequel on dépose tout d'abord successivement les unes sur les autres les couches (13,14,15,16) faisant partie de l'hétérostructure laser,
   - on fabrique une structure en forme de bande (15 avec 16) à partir au moins des couches (15,16) déposées en dernier lieu, et incluant la couche (15) prévue en tant que couche active pour l'effet laser,
   - on dépose sur cette hétérostructure une première couche supplémentaire (17) au moins dans les zones (71) flanquant latéralement la structure en forme de bande, et
   - déjà lors de l'exécution du dépôt de cette première couche (17) ou au moins ensuite, on exécute un traitement thermique lors duquel une substance dopante sort de cette troisième couche (17) et diffuse, à travers les zones, qui flanquent la structure en forme de bande, de la seconde couche contiguë (14), en pénétrant au moins dans des zones (71) qui jouxtent cette seconde couche (14) et pénètrent au moins dans la troisième couche (13).

FIG 1

FIG 2

FIG 3

FIG 4

FIG 5

FIG 6

FIG 7